# DEMANDE DE BREVET EUROPEEN

(11) **EP 4 583 410 A2**
(43) Date de publication de la demande: **09.07.2025**
(21) Numéro de dépôt: 24219605.3
(22) Date de dépôt: 12.12.2024
(51) Int. Cl.: H03M 1/74, G05F 3/26

(54) **CIRCUIT DE POLARISATION D'UN CONVERTISSEUR NUMÉRIQUE-ANALOGIQUE**

(30) Priorité: 15.12.2023 FR 2314251
(71) Demandeur: Commissariat à l'Energie Atomique et aux Energies Alternatives, 75015 Paris (FR)
(72) Inventeur: DUPONT, Bertrand, 38054 GRENOBLE Cedex 09 (FR)
(74) Mandataire: Atout PI Laplace

(57) **Abrégé**

L'invention concerne un circuit électronique comprenant :
- un noeud de sortie adapté pour fournir un courant de sortie à travers un circuit de charge ;
- une pluralité de branches sources élémentaires montés en parallèle ;
- un circuit de polarisation comprenant :
∘ un miroir de courant formé par une première branche de polarisation parcourue par un courant de référence et une deuxième branche de polarisation; la deuxième branche de polarisation comprend: un transistor suiveur, un premier transistor cascode de polarisation et un second transistor de recopie de courant de polarisation ;
∘ un premier circuit amplificateur configuré pour recopier le potentiel électrique du noeud de sortie sur le drain du premier transistor cascode de polarisation ;
∘ un second circuit amplificateur configuré pour générer une tension sur la grille du premier transistor cascode de polarisation pour réguler la tension de sa source à une tension de consigne prédéfinie.

## Description

L'invention concerne le domaine de circuits de conversion d'un signal numérique en un signal analogique, plus particulièrement la conception de circuit convertisseur analogique-numérique en courant avec une forte contrainte de linéarité.

Un convertisseur numérique-analogique est un dispositif électronique qui transforme des signaux numériques en signaux analogiques. Il est utilisé lorsque des données numériques doivent être converties en une forme analogique, par exemple pour être utilisées dans des systèmes audio ou pour contrôler des appareils analogiques. Le convertisseur numérique-analogique fonctionne en convertissant les données numériques, généralement exprimées en binaire, en une tension et/ou courant analogique correspondante.

Les convertisseurs numérique-analogique sont utilisés dans de nombreuses applications telles que les systèmes audio, les systèmes de contrôle industriel, les communications sans fil et les instruments de mesure. Ils sont essentiels pour permettre l'interaction entre les systèmes numériques et analogiques en convertissant les données numériques en signaux analogiques compréhensibles par les appareils analogiques.

Plus particulièrement, un circuit convertisseur numérique-analogique en courant est un dispositif électronique qui transforme des signaux numériques en courants analogiques proportionnels. Contrairement à un convertisseur numérique-analogique en tension qui génère une tension analogique en sortie, un convertisseur numérique-analogique en courant produit un courant analogique en sortie. Idéalement, le courant de sortie est directement proportionnel à la valeur numérique d'entrée. Ce courant peut ensuite être converti en une tension à travers une résistance de charge.

Le processus de conversion dans un circuit de convertisseur numérique-analogique en courant implique l'utilisation d'un réseau d'une pluralité de branches sources de courant élémentaires. Chaque valeur numérique d'entrée sélectionne une (ou plusieurs) branche source constituant un chemin spécifique pour le courant en activant ou désactivant des commutateurs correspondants. Cela permet de générer différents courants de sorties proportionnelles aux valeurs numériques d'entrée.

La conception d'un convertisseur numérique-analogique en courant est principalement contrainte par l'appariement des transistors, la dépendance du courant à la tension d'alimentation ou à la masse, ainsi que par l'impédance de sortie des branches sources de courant élémentaires qui composent le convertisseur. En ce qui concerne l'appariement et la dépendance des alimentations, cela peut être ajusté en utilisant des dimensions appropriées pour les transistors dans les sources de courant élémentaires.

Cependant, pour un convertisseur numérique-analogique en courant de N bits, il est nécessaire d'avoir 2^{N}-1 branches sources de courant élémentaires. L'impédance de sortie du convertisseur numérique-analogique en courant dépend du nombre de sources de courant activées. Lors d'une rampe de code allant de 0 à 2^{N}-1, la variation de l'impédance de sortie du convertisseur entraine une erreur de non-linéarité intégrée systématique.

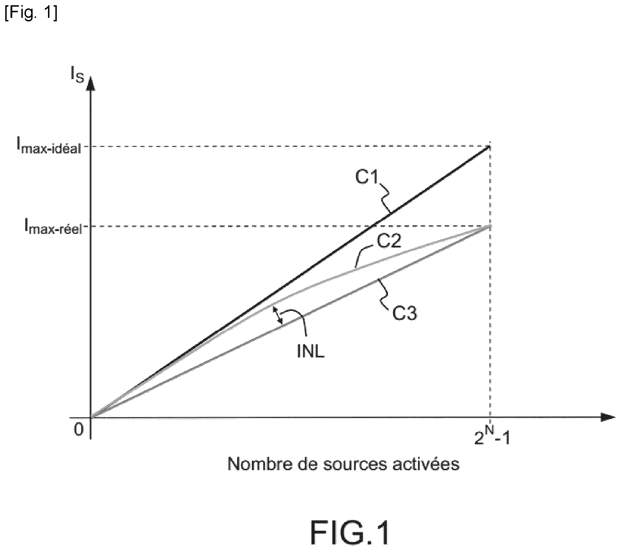

Afin de comprendre le problème de linéarité dans les convertisseurs numérique-analogique en courant, la figure 1 présente les courbes suivantes :
- La première courbe C1 présente la variation théorique du courant de sortie Iₛ du convertisseur selon le nombre de sources élémentaires activées. Le courant Is évolue entre zéro et une valeur de courant maximale idéale ;
- La seconde courbe C2 présente la variation réelle non linéaire du courant de sortie Iₛ du convertisseur selon le nombre de sources élémentaires activés. Le courant Is évolue entre zéro et une valeur de courant maximale réelle ;
- La troisième courbe C3 présente une modélisation linéaire théorique du courant de sortie Iₛ du convertisseur selon le nombre de sources élémentaires activés. Le courant Is évolue entre zéro et ladite valeur de courant maximale réelle.

Pour un convertisseur numérique-analogique, la valeur de courant maximale réelle Iₘₐₓ₋ᵣₑₑₗ mesurée est inférieure à la valeur de courant maximale idéale I_{max-ideal} calculée théoriquement. La non-linéarité est maximale pour un nombre intermédiaire de sources élémentaires activés, compris entre le nombre minimum et le nombre maximum des sources élémentaires activées. L'INL (Acronyme de l'expression anglaise Integrated Non Linearity) est une mesure qui évalue la linéarité d'un convertisseur numérique-analogique. Il s'agit d'une mesure du plus grand écart observé entre la deuxième courbe C2 et la troisième courbe C3 correspondant à un fonctionnement parfaitement linéaire entre zéro et la valeur de courant maximale réelle Iₘₐₓ₋ᵣₑₑₗ . Plus précisément, l'INL quantifie les écarts entre les valeurs de courant analogique réelles produites par le convertisseur et les valeurs idéales de la troisième courbe C3 attendues sur toute la plage de conversion. L'INL est généralement exprimé en LSB (Acronyme de l'expression anglaise Least Significant Bit). Un INL de 0 LSB signifie que le CNA produit des valeurs de tension parfaitement linéaires sans aucune erreur.

En ce sens, plusieurs problèmes ont été clairement identifiés avec les convertisseurs numérique-analogique en courant connus dans l'état de l'art ; et plus particulièrement les problèmes relatifs aux erreurs dues à la non-linéarité du comportement du convertisseur analogique-numérique pour un grand nombre de branches sources élémentaires activées.

En outre, lors de la conception d'un circuit convertisseur numérique-analogique, l'impédance de sortie doit être supérieure à un seuil critique qui dépend de l'INL spécifiée, de la résistance de charge et du nombre de bits du convertisseur numérique-analogique. Typiquement, pour une INL spécifiée de l'ordre de ½ LSB (acronyme de l'expression anglaise, Least Significant Bit), la valeur cible de l'impédance de sortie devient difficile à atteindre pour des convertisseurs numérique-analogique au-delà de 8-10 bits.

Plus généralement, l'invention peut s'appliquer pour des convertisseurs contraints en linéarité, en permettant la réduction de l'écart entre le comportement théorique et le comportement réel.

Nous allons commencer par introduire les solutions connues par l'Homme de l'art pour améliorer la linéarité d'un convertisseur analogique-numérique ayant une pluralité de branches sources de courant élémentaires.

La première solution selon l'état de l'art consiste à empiler une pluralité de transistors en cascode dans chaque branche. Les transistors en cascode sont dimensionnés de manière à augmenter l'impédance de sortie du circuit convertisseur et ainsi réduire l'amplitude de la non-linéarité. L'inconvénient de cette solution consiste non seulement à une augmentation considérable de la surface occupée par le circuit mais aussi à une réduction de la plage de variation de la tension de sortie aux bornes de la résistance de charge à la sortie du convertisseur.

La seconde solution selon l'état de l'art consiste à rajouter un module de correction digitale pour corriger les erreurs de conversion dues à la non-linéarité du comportement du convertisseur numérique-analogique en courant. Le circuit de correction digitale peut utiliser des techniques telles que la correction de gamma, la correction de linéarité, la correction d'interpolation pour ajuster les valeurs des signaux analogiques produites par le convertisseur. L'inconvénient de cette solution, c'est qu'elle nécessite l'introduction d'une complexité supplémentaire au système, ce qui engendre une augmentation considérable de la surface occupée par le circuit et une augmentation de sa consommation énergétique. Plus particulièrement, la solution selon l'état de l'art est basée sur la construction d'une table de correspondance (Look Up Table en anglais) qui consiste à faire correspondre le code numérique reçu en entrée à un code modifié qui permet de faire en sorte que la courbe mesurée se rapproche autant que possible de la courbe idéale. Cela nécessite l'implémentation d'une large mémoire pour stocker cette table. Cela engendre une augmentation considérable de la surface occupée par le circuit.

Pour pallier les limitations des solutions existantes, l'invention propose un circuit convertisseur analogique-numérique dans lequel le circuit de polarisation comprend au moins un circuit amplificateur permettant l'augmentation de l'impédance de sortie vue par les branches sources de courants élémentaires. Plusieurs modes de réalisation de l'invention sont présentés avec des variantes d'implémentation de la solution proposée.

L'invention a pour objet un circuit électronique configuré pour convertir un signal numérique d'entrée de N bits en un courant de sortie, avec N un entier naturel non-nul, ledit circuit comprenant :
- un noeud d'alimentation adapté à recevoir une tension d'alimentation, et une masse électrique ;
- un noeud de sortie adapté à fournir ledit courant de sortie à travers un circuit de charge cible monté entre d'une part ledit noeud de sortie et d'autre part un premier noeud de référence choisi parmi la masse électrique ou le noeud d'alimentation ;
- une pluralité de branches sources élémentaires, montés en parallèle entre le noeud de sortie et un second noeud de référence distinct dudit premier noeud de référence et choisi parmi la masse électrique ou le noeud d'alimentation ; chaque branche source élémentaire comprenant :
   ∘ un transistor de contrôle commandé par un bit et ayant un drain connecté au noeud de sortie ;
   ∘ un transistor cascode élémentaire et un transistor élémentaire de recopie de courant montés en série avec le transistor de contrôle ;
- un circuit de polarisation comprenant :
   ∘ un miroir de courant formé par une première branche de polarisation parcourue par un courant de référence et une deuxième branche de polarisation ; la première branche de polarisation comprend un premier générateur dudit courant de référence et un premier transistor de recopie de courant de polarisation recevant le courant de référence ;
      la deuxième branche de polarisation comprend dans cet ordre : un transistor suiveur, un premier transistor cascode de polarisation et un second transistor de recopie de courant de polarisation montés en série ; la grille du second transistor de recopie de courant de polarisation et la grille de chaque transistor élémentaire de recopie de courant étant connectées à la grille du premier transistor de recopie de courant de polarisation ; la grille de chaque transistor cascode élémentaire étant connectée à la grille du premier transistor cascode de polarisation ;
   ∘ un premier circuit amplificateur configuré pour recopier le potentiel électrique du noeud de sortie sur le drain du premier transistor cascode de polarisation ;
   ∘ un second circuit amplificateur configuré pour générer une tension sur la grille du premier transistor cascode de polarisation pour réguler la tension de la source dudit premier transistor cascode de polarisation à une tension de consigne prédéfinie.

Selon un aspect particulier de l'invention, le premier circuit amplificateur est un amplificateur opérationnel ayant une entrée non-inverseuse connectée au noeud de sortie, une entrée inverseuse connectée au drain du premier transistor cascode de polarisation et une sortie connectée à la grille du transistor suiveur.

Selon un aspect particulier de l'invention, le deuxième circuit amplificateur est un amplificateur opérationnel ayant une entrée non-inverseuse configurée pour recevoir une première tension de polarisation, une entrée inverseuse connectée à la source du premier transistor cascode de polarisation et une sortie connectée à la grille du premier transistor cascode de polarisation et destinée à générer ladite tension régulée.

Selon un aspect particulier de l'invention, le deuxième circuit amplificateur comprend un deuxième générateur de courant et un premier transistor d'amplification alimenté par ledit deuxième générateur de courant dédié et ayant :
- une grille connectée à la source du premier transistor cascode de polarisation ;
- et un drain connecté à la grille du du premier transistor cascode de polarisation.

Selon un aspect particulier de l'invention, la première branche de polarisation comprend un second transistor cascode de polarisation monté entre le premier générateur du courant de référence et le premier transistor de recopie de courant de polarisation.

Selon un aspect particulier de l'invention, le circuit de polarisation comprend en outre un troisième circuit amplificateur ayant une entrée non-inverseuse configurée pour recevoir une seconde tension de polarisation, une entrée inverseuse connectée à la source du second transistor cascode de polarisation et une sortie connectée à la grille du second transistor cascode de polarisation.

Selon un aspect particulier de l'invention, la seconde tension de polarisation correspond à la première tension de polarisation.

Selon un aspect particulier de l'invention, le circuit de polarisation comprend en outre un second transistor d'amplification alimenté par un troisième générateur de courant dédié et ayant une grille connectée à la source du second transistor cascode de polarisation et ayant un drain connecté à la grille du second transistor cascode de polarisation .

L'invention a également pour objet un dispositif photonique à phase configurable comprenant :
- un guide d'ondes pour guider un faisceau lumineux d'entrée généré par une source laser ;
- une antenne d'émission ou de réception connectée au guide d'ondes ;
- un élément résistif destiné à chauffer par effet joule le guide d'ondes de manière à piloter l'indice de propagation du guide d'ondes pour configurer la phase faisceau lumineux déphasé ;
- un circuit électronique selon l'invention configuré pour injecter un courant de commande à travers l'élément résistif à partir d'un signal numérique de commande pour piloter l'échauffement d'au moins une section du guide d'ondes ; l'élément résistif correspondant audit circuit de charge cible.

L'invention a également pour objet un réseau optique à commande de phase configuré pour diriger un faisceau lumineux selon une direction prédéterminée comprenant : une pluralité de dispositifs photoniques à phase configurable selon l'invention alimentés par une source laser commune ; chaque dispositif photonique à phase configurable étant commandé par un signal numérique de commande dédié généré par des moyens de contrôle.

D'autres caractéristiques et avantages de la présente invention apparaîtront mieux à la lecture de la description qui suit en relation aux dessins annexés suivants.
[Fig. 1] la figure 1 illustre des courbes du comportement d'un convertisseur numérique-analogique en courant selon l'état de l'art. Cette figure est déjà décrite dans une section précédente.
[Fig. 2] la figure 2 illustre un schéma électronique du convertisseur numérique-analogique selon un premier mode de réalisation de l'invention.
[Fig. 3] la figure 3 illustre un schéma électronique du convertisseur numérique-analogique selon un deuxième mode de réalisation de l'invention.
[Fig. 4] la figure 4 illustre un schéma électronique du convertisseur numérique-analogique selon un troisième mode de réalisation de l'invention.
[Fig. 5a] la figure 5a illustre un premier dispositif photonique mettant en oeuvre le circuit convertisseur selon l'invention.
[Fig. 5b] la figure 5b illustre un second dispositif photonique mettant en oeuvre le circuit convertisseur selon l'invention.

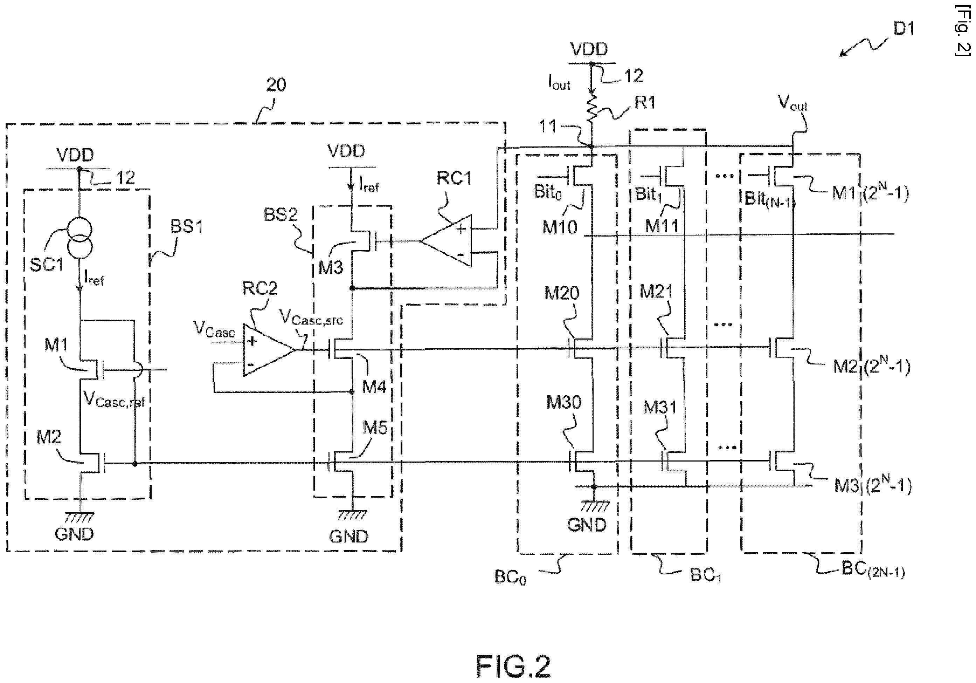

La figure 2 illustre un schéma électronique du circuit convertisseur numérique-analogique D1 selon un premier mode de réalisation de l'invention. Le circuit D1 est configuré pour convertir un signal numérique d'entrée BW = [Bit₀ Bit₁ Bit₂ Bit₃ ... Bit_{N-1}] de N bits de rang i=0 à N-1 en un courant de sortie Iₒᵤₜ., avec N un entier naturel non-nul. Le circuit D1 comprend un noeud de sortie 11 adapté à fournir un signal analogique de sortie Vₒᵤₜ, un noeud d'alimentation 12 adapté à recevoir une tension d'alimentation VDD, une pluralité de branches sources élémentaires BCⱼ de rang j=0 à 2^{N}-1 et un circuit de polarisation 20.

Un circuit de charge cible est connecté au circuit convertisseur numérique-analogique D1. Le circuit de charge cible est destiné à recevoir le courant de sortie Iₒᵤₜ. Le circuit de charge cible peut être à titre d'exemple indicatif et non limitatif un élément résistif ou un élément inductif ou un élément capacitif ou un circuit électronique à alimenter par le courant de sortie Iₒᵤₜ. Dans le reste de la description, le circuit de charge cible est réalisé par un élément résistif R1 mais l'invention reste compatible avec tout circuit de charge recevant le courant de sortie Iₒᵤₜ selon le contexte applicatif de l'invention. Un circuit de charge cible formé par au moins un élément inductif permet par exemple de réaliser un convertisseur de puissance. Un circuit de charge cible formé par au moins un élément capacitif permet par exemple de réaliser un circuit d'échantillonnage. Un circuit de charge cible à alimenter par le courant de sortie Iₒᵤₜ est par exemple un amplificateur ou un circuit logique.

Dans l'exemple illustré, l'élément résistif R1 est monté entre le noeud d'alimentation 12 et le noeud de sortie11. L'élément résistif R1 est destiné à être parcouru par le courant de sortie Iₒᵤₜ dont l'intensité dépend du signal numérique d'entrée BW. L'élément résistif R1 permet ainsi de convertir le courant de sortie Iₒᵤₜ en une chute de tension entre le noeud d'alimentation 12 et le noeud de sortie11 et ainsi en un signal analogique de sortie Vₒᵤₜ.

Alternativement, l'élément résistif R1 utilise le courant de sortie Iₒᵤₜ pour produire par effet Joule une quantité de chaleur. Cela est utile pour des applications nécessitant un échauffement local et modulable aux alentours de l'élément résistif R1.

Le circuit convertisseur numérique-analogique D1 comprend 2^{N}-1 branches sources élémentaires BCⱼ montés en parallèle entre le noeud de sortie11 et la masse électrique GND. Chaque branche source élémentaire BCⱼ comprend un transistor de contrôle M1j, un transistor cascode élémentaire M2j et un transistor élémentaire de recopie de courant M3j.

Pour chaque branche source élémentaire BCⱼ de rang j, le drain du transistor de contrôle M1j est connecté au noeud de sortie 11 commun à toutes les branches sources; le drain du transistor cascode élémentaire M2j est connecté à la source du transistor de contrôle M1j; le drain du transistor élémentaire de recopie de courant M3j est connecté à la source du transistor cascode élémentaire M2j; la source du transistor élémentaire de recopie de courant M3j est connectée à la masse électrique GND ; la grille du transistor de contrôle M1j est commandé par un bit du signal numérique d'entrée BW et les grilles respectives du transistor cascode élémentaire M2j et du transistor élémentaire de recopie de courant M3j sont polarisées par le circuit de polarisation 20. Ainsi l'impédance de sortie r_{ds} des deux transistors M2j, M3j de la branche source élémentaire BCⱼ est en partie déterminée par le circuit de polarisation 20. La combinaison des transistors M2j, M3j de la branche source élémentaire BCⱼ se comporte comme une source de courant ayant une impédance de sortie r_{ds.}. Le transistor de contrôle M1j joue le rôle d'un interrupteur de courant dans la branche source élémentaire BCⱼ. Lorsque le transistor de contrôle M1j est à l'état passant, un chemin de courant est établi du noeud d'alimentation 12 vers masse électrique GND à travers l'impédance de charge R1 et ensuite la branche source élémentaire BCⱼ associée audit transistor de contrôle. Ainsi, chaque branche source élémentaire BCⱼ présente une capacité de génération d'un courant élémentaire I_{src} à travers l'impédance de charge R1. Dans le cas où le dimensionnement des transistors des branches sources est identique, les courants élémentaires sont identiques. Dans ce cas, idéalement, lorsque les bits du signal numérique d'entrée BW activent M branches sources, le courant de sortie Iₒᵤₜ traversant l'impédance de charge R1 est égal à M fois le courant élémentaire I_{src}. les transistors de chaque branche source élémentaire BCⱼ sont dimensionnés de manière à fonctionner en régime de saturation pour une valeur de courant de sortie maximal Iₒᵤₜ prédéterminée, une tension d'alimentation VDD prédéterminée et une valeur de l'impédance de sortie prédéterminée.

Pour tenir compte du poids des bits dans le signal numérique d'entrée BW = [Bit₀ Bit₁ Bit₂ Bit₃ Bit_{N-1}], la distribution des bits par rapport aux transistors de contrôle M1j est réalisée de la manière suivante : le bit de rang i=0 Bit₀ ayant le poids le plus faible (à titre d'exemple illustratif et non limitatif) commande la grille du transistor de contrôle M10 de la branche source élémentaire BC₀ ; le bit de rang i=1 Bit₁ ayant le poids suivant commande les grilles des transistors de contrôle M11 et M12 des 2^{I=1} branches sources suivantes BC₁ et BC₂ ; le bit de rang i=2 Bit₂ ayant le poids suivant commande les grilles des transistors de contrôle M13 à M16 des 2ⁱ⁼² branches sources suivantes BC₃ à BC₆ et ainsi de suite jusqu'au bit Bit_{N-1} de rang N-1 qui commande les grilles des transistors de contrôle des 2^{N}-1 dernières branches sources BCⱼ. L'ordre séquentiel de la distribution a été décrit pour faciliter la compréhension de la distribution de commande mais il n'est pas obligatoire. De manière générale, le bit de rang i=0 à N-1 commande les grilles des transistors de contrôle de 2ⁱ branches sources BCⱼ choisies parmi les 2^{N}-1 branches sources du circuit convertisseur D1. Ainsi, lorsque le bit de rang i Bit; (et donc de poids i) est à l'état logique « 1 », les 2ⁱ branches sources BC associées sont passantes. Cela induit l'injection d'un courant associé audit bit Bitᵢ; le courant injecté est proportionnel au poids dudit bit Bitᵢ et est égal à 2' * I_{src}.

Il est également envisageable d'ajouter un circuit numérique (non représenté) configure pour convertir le signal numérique d'entrée BW pour convertir les bits de poids fort en codes thermométriques pour commander les grilles des transistors de contrôle M1j ce qui réduire les inconvénients relatifs à la non-linéarité différentielle (DNL Differential Non Linearity) du convertisseur.

Le circuit de polarisation 20 comprend un miroir de courant formé par une première branche de polarisation BS1 parcourue par un courant de référence I_{ref} et une deuxième branche de polarisation BS2 couplée à la première branche de polarisation BS1. La première branche de polarisation BS1 comprend un premier générateur SC1 dudit courant de référence I_{ref}, un premier transistor de recopie de courant de polarisation M2.

La deuxième branche de polarisation BS2 comprend dans cet ordre : un transistor suiveur M3, un premier transistor cascode de polarisation M4 et un second transistor de recopie de courant de polarisation M5 montés en série en partant du noeud d'alimentation 12 vers la masse électrique GND.

L'implémentation spécifique illustrée du miroir de courant formé par les branches de polarisation BS1, BS2 est exposée à titre indicatif et non limitatif. L'invention reste compatible avec toutes architectures de miroir de courant de manière générale.

Avantageusement, et de manière optionnelle, la première branche de polarisation BS1 comprend un second transistor cascode de polarisation M1. Le second transistor cascode de polarisation M1 permet d'améliorer la recopie de courant de la première branche de polarisation BS1 vers la deuxième branche de polarisation BS2. Dans une implémentation sans second transistor cascode de polarisation M1, le premier transistor de recopie de courant de polarisation M2 est monté en diode directement connectée au premier générateur SC1.

Plus particulièrement, le premier générateur de courant SC1 est monté entre le noeud d'alimentation 12 et le drain du second transistor cascode de polarisation M1. Le drain du premier transistor de recopie de courant de polarisation M2 est connecté à la source du second transistor cascode de polarisation M1. La source du premier transistor de recopie de courant de polarisation M2 est connectée à la masse électrique GND. La grille du transistor de recopie de courant de polarisation M2 est connectée à la sortie du premier générateur de courant SC1. Dans le premier mode de réalisation, le second transistor cascode de polarisation M1 est polarisé par une tension de référence (aussi appelée tension consigne) V_{casc,ref} provenant d'une source externe non représentée.

La grille du premier transistor de recopie de courant de polarisation M2 est connectée au drain du second transistor cascode de polarisation M1 et à la grille du second transistor de recopie du courant de polarisation M5. Le montage en cascode du second transistor cascode de polarisation M1 permet d'imposer une tension de drain au second transistor de recopie de courant de polarisation M2. Le drain du transistor suiveur M3 est connecté au noeud d'alimentation 12. Le drain du premier transistor cascode de polarisation M4 est connecté à la source du transistor suiveur M3. Le drain du second transistor de recopie de courant de polarisation M5 est connecté à la source du premier transistor cascode de polarisation M4. La source du second transistor de recopie de courant de polarisation M5 est connectée à la masse électrique GND. En reliant les grilles du premier transistor de recopie M2 et du second transistor de recopie M5 et en ayant un potentiel très proche sur les drains de M2 et de M5, on s'assure de bien recopier le courant de référence I_{ref} (ou un multiple de I_{ref}) de la première branche de polarisation BS1 dans la deuxième branche de polarisation BS2, notamment car on limite ainsi l'effet Early.

Pour chaque branche source élémentaire BCⱼ, la grille du transistor cascode élémentaire M2j est connectée à la grille du premier transistor cascode de polarisation M4 de la deuxième branche de polarisation BS2. Cela permet de coupler chaque branche source élémentaire BCⱼ à la deuxième branche de polarisation BS2. De plus, pour chaque branche source élémentaire BCⱼ, la grille du transistor élémentaire de recopie de courant M3j est connectée à la grille du premier transistor de recopie de courant de polarisation M2 de la première branche de polarisation BS1 Cela permet de coupler chaque branche source élémentaire BCⱼ à la première branche de polarisation BS1. Le double couplage de chaque branche source élémentaire BCⱼ permet de recopier le courant de référence (ou un multiple du courant) à l'une quelconque des branches sources BCⱼ lorsque cette dernière est à l'état passant.

Le circuit de polarisation 20 comprend également un premier circuit amplificateur RC1 configuré pour recopier la tension de sortie Vₒᵤₜ sur le drain du premier transistor cascode de polarisation M4. Cela permet d'obtenir un comportement de la deuxième branche de polarisation BS2 similaire à celui des branches sources BCⱼ qui voient les variations de la tension de sortie Vₒᵤₜ pendant le fonctionnement du circuit convertisseur numérique-analogique D1. L'amélioration de la similarité des variations de tensions vues par la deuxième branche de polarisation BS2 et les branches sources BCⱼ permet d'améliorer la linéarité du convertisseur numérique-analogique D1. A titre d'exemple, le circuit amplificateur RC1 est un amplificateur opérationnel ayant une entrée non-inverseuse connectée au noeud de sortie 11, une entrée inverseuse connectée au drain du premier transistor cascode de polarisation M4 et une sortie connectée à la grille du transistor suiveur M3.

Le circuit de polarisation 20 comprend en outre un deuxième circuit amplificateur RC2, configuré pour générer une tension régulée V_{casc,src} sur la grille du premier transistor cascode de polarisation M4 à partir d'au moins la tension de la source dudit premier transistor cascode de polarisation M4. La combinaison du deuxième circuit amplificateur RC2 avec le transistor cascode de polarisation M4 forme un cascode régulé (traduction de l'expression anglaise regulated cascode). De plus, le deuxième circuit amplificateur RC2 est monté de manière à réguler la tension de grille du premier transistor cascode de polarisation M4 et ainsi maintenir le drain du second transistor de recopie de courant de polarisation M5 à une première tension de polarisation prédéterminée V_{casc}.

Selon le premier mode de réalisation, le deuxième circuit amplificateur RC2 est réalisé par un amplificateur opérationnel ayant une entrée non-inverseuse configurée pour recevoir une première tension de polarisation V_{casc}, une entrée inverseuse connectée à la source du premier transistor cascode de polarisation M4 et une sortie connectée à la grille du premier transistor cascode de polarisation M4 et destinée à générer la tension régulée V_{casc,src}. Ce montage du deuxième circuit amplificateur RC2 permet d'augmenter l'impédance de sortie du circuit convertisseur D1 et ainsi améliorer la linéarité du courant de sortie Iₒᵤₜ en fonction du nombre de branches sources BCⱼ activées. En effet, l'utilisation du deuxième amplificateur RC2, de gain A, monté en « regulated cascode » permet de multiplier l'impédance de sortie rₒᵤₜ d'un facteur de A+1 par rapport à un montage cascode selon l'état de l'art, sans le deuxième amplificateur RC2. Avantageusement, la puissance de sortie du deuxième circuit amplificateur RC2 est supérieure à quatre fois celle du premier circuit amplificateur RC1. Cela permet au deuxième circuit amplificateur RC2 de piloter les grilles des 2^{N}-1 transistors de charge M2j en plus de la grille du premier transistor cascode de polarisation M4.

Nous avons décrit une combinaison d'éléments techniques formée par : d'une part, le premier amplificateur RC1 qui recopie la tension de sortie Vₒᵤₜ dans la deuxième branche de polarisation BS2 ; et d'autre part le deuxième circuit amplificateur RC2 qui régule la tension de grille du premier transistor cascode de polarisation M4. Cette combinaison permet d'obtenir une linéarité améliorée du courant de sortie Iₒᵤₜ en fonction du nombre de branches sources BCⱼ activées (et donc en fonction des bits à l'état logique « 1 »). On améliore ainsi la linéarité du courant de sortie tout en évitant d'agrandir ou d'ajouter plusieurs étages de cascode dans les branches sources BCⱼ. La solution selon l'invention permet alors de gagner en surface occupée par le circuit convertisseur par rapport aux solutions de l'état de l'art sans dégrader la linéarité.

Avantageusement, et de manière optionnelle, chaque branche source élémentaire BCⱼ ne se limite pas à un seul transistor cascode élémentaire M2j et comprend ainsi une pluralité de transistors cascode élémentaire M2j, M2j', M2j"... Avantageusement, et de manière optionnelle, la seconde branche de polarisation BS2 ne se limite pas à un seul premier transistor cascode de polarisation M4 et comprend ainsi une pluralité de transistors cascode de polarisation M4, M4', M4"... La polarisation d'au moins un transistor cascode de polarisation parmi la dite pluralité transistors cascode de polarisation est régulée par au moins un circuit amplificateur RC2 monté comme décrit précédemment.

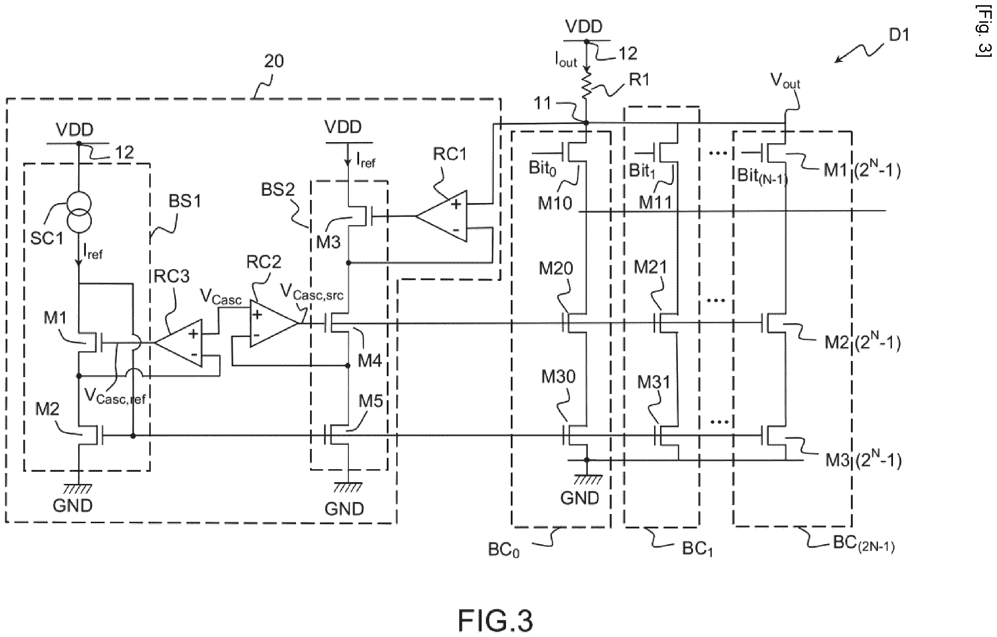

La figure 3 illustre un schéma électronique du convertisseur numérique-analogique D1 selon un deuxième mode de réalisation de l'invention. Les caractéristiques structurelles et fonctionnelles décrites pour le premier mode de réalisation restent valables pour le deuxième mode de réalisation. Dans le mode illustré, le circuit de polarisation 20 comprend en outre un troisième circuit amplificateur RC3 ayant une entrée non-inverseuse configurée pour recevoir une seconde tension de polarisation V_{casc}, une entrée inverseuse connectée à la source du second transistor cascode de polarisation M1 et une sortie connectée à la grille du second transistor cascode de polarisation M1. Le troisième circuit amplificateur RC3 permet alors de commander la grille du second transistor cascode de polarisation M1 de la première branche de polarisation BS1 et de maintenir le drain du premier transistor de recopie de courant de polarisation M2 à la seconde tension de polarisation prédéterminée V_{casc.} La combinaison du troisième circuit amplificateur RC3 avec le second transistor cascode de polarisation M1 forme un montage cascode régulé. Cela permet d'améliorer la symétrie et ainsi la recopie de courant entre la première branche de polarisation BS1 et la seconde branche de polarisation BS2. Dans le cas illustré, et de manière optionnelle, la seconde tension de polarisation correspond aussi à la première tension de polarisation V_{casc} du deuxième circuit amplificateur RC2.

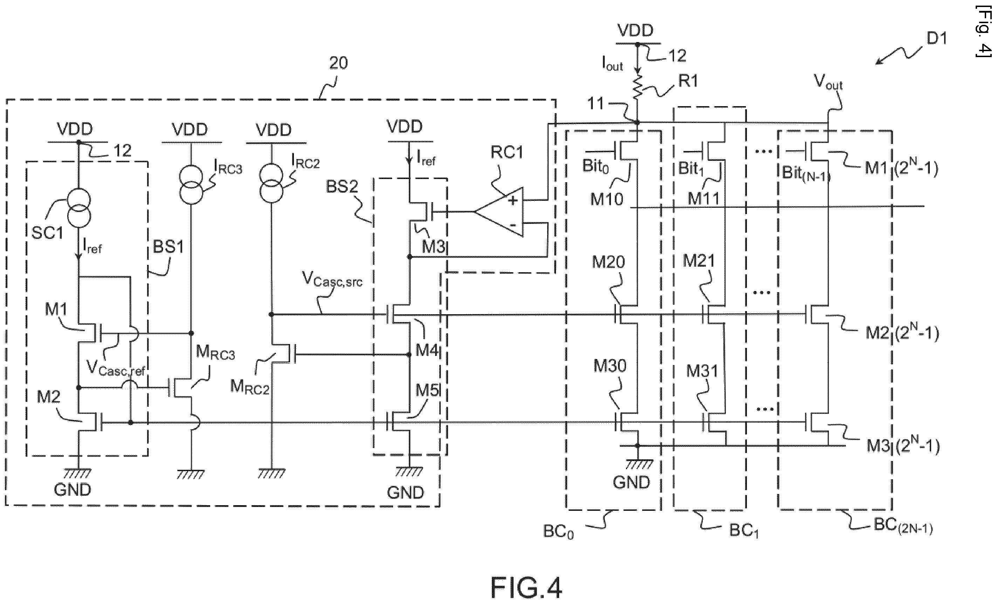

La figure 4 illustre un schéma électronique du convertisseur numérique-analogique D1 selon un troisième mode de réalisation de l'invention. Les caractéristiques structurelles et fonctionnelles décrites pour le premier et le deuxième mode de réalisation restent valables pour le troisième mode de réalisation. La différence avec les autres modes de réalisation consiste en une implémentation alternative du deuxième circuit amplificateur et/ou du troisième circuit amplificateur tout en gardant les mêmes avantages techniques relatifs à ces deux éléments.

Dans ce mode de réalisation, le deuxième circuit amplificateur comprend un deuxième générateur de courant I_{RC2} et un premier transistor d'amplification M_{RC2} alimenté par ledit deuxième générateur de courant dédiée I_{Rc2}. La grille du premier transistor d'amplification M_{RC2} est connectée au drain du second transistor de recopie de courant de polarisation M5 (et donc à la source dudit premier transistor cascode de polarisation M4). Le drain du premier transistor d'amplification M_{RC2} est connecté à la grille du premier transistor cascode de polarisation M4. Dans ce mode de réalisation, la première tension de polarisation V_{casc} correspond à la tension grille-source V_{GS,MRC2} du premier transistor d'amplification M_{RC2}. Le premier transistor d'amplification M_{RC2} est monté en amplificateur source commune. Le choix de l'intensité du courant I_{RC2} et le dimensionnement en largeur et longueur du premier transistor d'amplification M_{RC2} permettent de générer une tension régulée V_{casc,src} sur la grille du premier transistor cascode de polarisation M4 à partir de la tension de la source dudit premier transistor cascode de polarisation M4.

De même, dans ce mode de réalisation, le troisième circuit amplificateur comprend un troisième générateur de courant I_{RC3} et un second transistor d'amplification M_{RC3} alimenté par ledit troisième générateur de courant dédiée I_{RC3}. La grille du second transistor d'amplification M_{RC2} est connectée au drain du premier transistor de recopie de courant de polarisation M2 (et donc à la source du second transistor cascode de polarisation M1). Le drain du second transistor d'amplification M_{RC3} est connecté à la grille du second transistor cascode de polarisation M1. Dans ce mode de réalisation, la seconde tension de polarisation V_{casc} correspond à la tension grille-source V_{GS,MRC3} du second transistor d'amplification M_{RC3}. Le second transistor d'amplification M_{RC3} est monté en amplificateur source commune. Le choix de l'intensité du courant I_{RC3} et le dimensionnement en largeur et longueur du second transistor d'amplification M_{RC3} permettent de générer une tension régulée V_{casc,ref} sur la grille du second transistor cascode de polarisation M1 à partir de la tension de la source dudit second transistor cascode de polarisation M1.

Nous soulignons que les choix d'implémentation pour réaliser le deuxième et troisième circuit amplificateur sont indépendants. Il est possible d'opter pour :
d'un côté un amplificateur opérationnel différentiel pour réaliser le deuxième circuit amplificateur et d'un autre côté un montage d'un transistor d'amplification en source-commune pour réaliser le troisième circuit amplificateur ; ou inversement.

De manière générale pour tous les modes de réalisation de l'invention, la combinaison du premier circuit amplificateur RC1 et le deuxième circuit amplificateur RC2 (ou M_{RC2}) présente une synergie permettant de réguler en même temps la polarisation du drain et de la source du premier transistor cascode de polarisation M4 et ainsi réguler la polarisation de la grille dudit premier transistor cascode de polarisation M4. La régulation de la polarisation de ladite grille permet de réduire l'écart entre le comportement réel et le comportement théorique du circuit convertisseur du convertisseur numérique-analogique D1.

L'invention a été exposée avec des transistors de type NMOS à titre d'exemple illustratif non limitatif. Rien n'empêche d'implémenter la même solution avec des transistors de type PMOS. Alternativement, l'Homme du métier adapte l'architecture proposée et décrite dans les figures 2 à 4 avec une implémentation basée sur des transistors PMOS et/ou une implémentation mixte complémentaire NMOS/PMOS. Dans le cas d'une implémentation exclusivement en PMOS, le circuit de charge cible est monté entre le noeud de sortie 11 et la masse électrique GND; les branches sources élémentaires BCⱼ sont montés en parallèles entre le noeud de sortie 11 et le noeud d'alimentation 12.

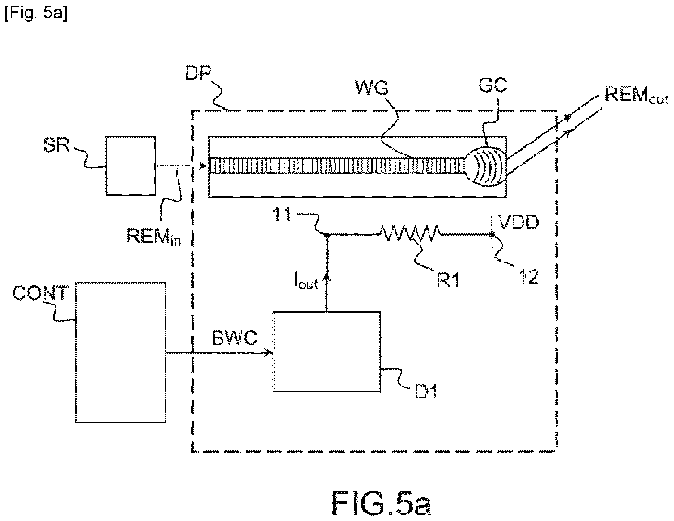

La figure 5a illustre un premier dispositif photonique DP mettant en oeuvre le circuit convertisseur selon l'invention.

L'invention est applicable dans le contexte d'un premier dispositif photonique à phase configurable DP. Le dispositif photonique DP comprend un guide d'ondes WG, une antenne d'émission GC, un élément résistif R1 et un circuit électronique D1 convertisseur numérique-analogique selon l'un quelconque des modes de réalisation de l'invention.

Le guide d'ondes WG est configuré pour guider un faisceau lumineux d'entrée REMᵢₙ généré par une source laser SR. Le guide d'ondes WG est une microstructure intégrée sur un substrat en un matériau semi-conducteur. La source laser peut être externe ou intégrée sur le même substrat semi-conducteur.

L'antenne d'émission GC est connectée à la sortie du guide d'ondes WG et configurée pour émettre un faisceau lumineux déphasé REMₒᵤₜ. L'antenne d'émission GC est réalisée par un coupleur à réseau de diffraction (traduction du terme en anglais Grating Coupler) intégré sur le substrat semi-conducteur.

L'élément résistif R1 correspond au circuit de charge cible monté au noeud de sortie 11 du circuit électronique D1 convertisseur numérique-analogique. L'élément résistif R1 est destiné à chauffer par effet joule le guide d'ondes WG de manière à piloter l'indice de propagation du guide d'ondes WG pour configurer la phase du faisceau lumineux déphasé REMₒᵤₜ.

La modification locale de l'indice de propagation permet de modifier la phase de la fraction du signal émis par source laser SR qui passe par le guide d'ondes WG et qui poursuit jusqu'à l'antenne d'émission GC. La résistance de l'élément résistif R1 est comprise entre 10Ω et 100KΩ. Le circuit convertisseur numérique-analogique D1 est configuré pour commander l'intensité du courant parcourant élément résistif R1 à partir d'un signal numérique de commande BWC. Le signal numérique de commande BWC est généré par une unité de contrôle CONT. Le signal numérique de commande BWC est codé selon l'échauffement souhaité qui dépend du déphasage ciblé.

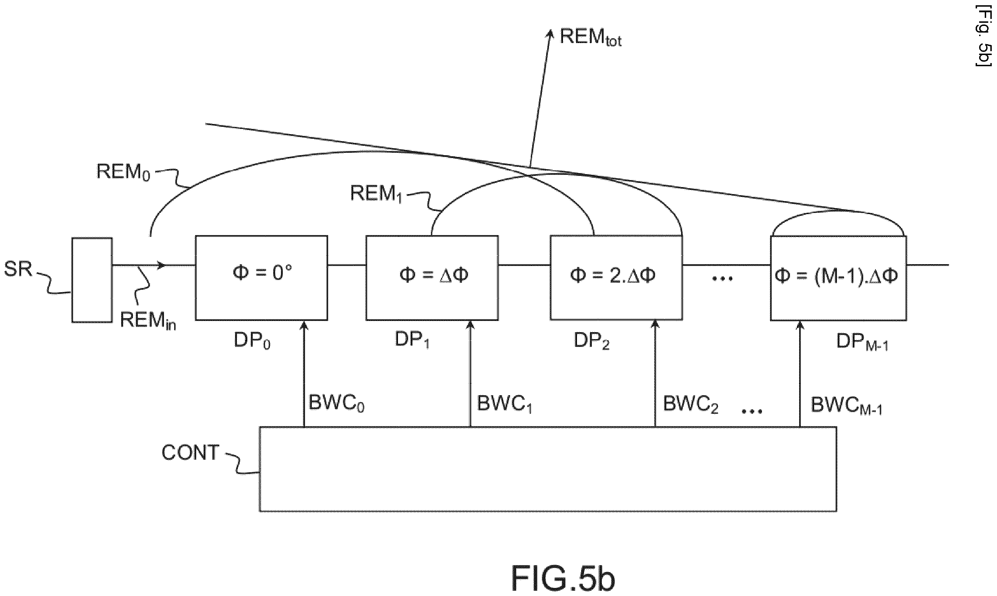

La figure 5b illustre un second dispositif photonique OPA mettant en oeuvre le circuit convertisseur selon l'invention. Le second dispositif photonique OPA est un réseau optique à commande de phase. L'invention présente un intérêt particulier dans le contexte d'un dispositif photonique de type réseau optique à commande de phase (traduction de l'expression en anglais Optical Phase Array). Un réseau optique à commande de phase est un dispositif photonique qui permet de diriger un faisceau lumineux selon une direction prédéterminée sans utiliser de pièces mécaniques.

Le second dispositif photonique OPA comprend une pluralité de dispositifs photoniques DPₘ à phase configurable de rang m=0 à M-1. Les dispositifs photoniques DPₘ à phase configurable forment un réseau photonique. Chaque dispositif photonique DPₘ à phase configurable reçoit un signal numérique de commande BWCₘ dédié de l'unité de contrôle CONT. L'ensemble des guides d'ondes WG des dispositifs photoniques DPₘ sont alimentés par une source laser SR commune. La source laser SR commune génère un faisceau lumineux d'entrée REMᵢₙ qui est fractionné en M fractions. Chaque fraction est guidée par le guide d'onde WG d'un dispositif photonique DPₘ associé. Idéalement, les dispositifs photoniques à phase configurable DPₘ sont configurés de manière à créer un déphasage constant (modulo 2.pi) pour chaque dispositif photonique DPₘ à phase configurable de rang m par rapport au dispositif photonique DPₘ₊₁ à phase configurable suivant de rang m+1. Le faisceau lumineux de sortie est obtenu par la superposition des différents faisceaux lumineux déphasés REM₀, REM₁ jusqu'à REM_{M}_₁.

A titre d'exemple non limitatif, le dispositif photonique D2 comprend un réseau de 256 dispositifs photoniques DPₘ à phase configurable et ainsi 256 circuits convertisseurs numérique-analogique D1 dans un circuit CMOS de 5×5mm². Dans ce contexte, la solution selon l'invention présente un avantage particulier lié à une surface réduite des 256 circuits convertisseurs numérique-analogique D1 combiné avec une linéarité améliorée. La linéarité améliorée permet d'injecter un déphasage plus précis entre les différentes antennes de l'OPA
L'implémentation du circuit convertisseur selon l'invention a été décrite pour un dispositif photonique d'émission à titre indicatif et non limitatif. L'invention reste compatible et présente les mêmes avantages également pour un dispositif photonique dans lequel l'antenne GC est configurée en réception. Dans ce cas, les antennes GC reçoivent un flux de la scène et il est possible privilégier une direction de réception en modulant les phases des antennes.

## Revendications

1. Circuit électronique (D1 ) configuré pour convertir un signal numérique d'entrée (BW) de N bits en un courant de sortie (Iₒᵤₜ), avec N un entier naturel non-nul, ledit circuit (D1) comprenant :
- un noeud d'alimentation (12) adapté à recevoir une tension d'alimentation (VDD), et une masse électrique (GND) ;
- un noeud de sortie (11) adapté à fournir ledit courant de sortie (Iₒᵤₜ) à travers un circuit de charge cible (R1) monté entre d'une part ledit noeud de sortie (11) et d'autre part un premier noeud de référence choisi parmi la masse électrique (GND) ou le noeud d'alimentation (12) ;
- une pluralité de branches sources élémentaires (BC₀, BCᵢ, BC_{K}), montés en parallèle entre le noeud de sortie (11) et un second noeud de référence distinct dudit premier noeud de référence et choisi parmi la masse électrique (GND) ou le noeud d'alimentation (12); chaque branche source élémentaire (BCᵢ) comprenant :
∘ un transistor de contrôle (M10, M11) commandé par un bit et ayant un drain connecté au noeud de sortie (11) ;
∘ un transistor cascode élémentaire (M20, M21) et un transistor élémentaire de recopie de courant (M30,M31) montés en série avec le transistor de contrôle (M10, M11) ;
- un circuit de polarisation (20) comprenant :
∘ un miroir de courant formé par une première branche de polarisation (BS1) parcourue par un courant de référence (I_{ref}) et une deuxième branche de polarisation (BS2) ; la première branche de polarisation (BS1) comprend un premier générateur (SC1) dudit courant de référence (I_{ref}) et un premier transistor de recopie de courant de polarisation (M2) recevant le courant de référence (Iref) ;
la deuxième branche de polarisation (BS2) comprend dans cet ordre : un transistor suiveur (M3), un premier transistor cascode de polarisation (M4) et un second transistor de recopie de courant de polarisation (M5) montés en série ; la grille du second transistor de recopie de courant de polarisation (M5) et la grille de chaque transistor élémentaire de recopie de courant (M30, M31) étant connectées à la grille du premier transistor de recopie de courant de polarisation (M2); la grille de chaque transistor cascode élémentaire (M20, M21) étant connectée à la grille du premier transistor cascode de polarisation (M4) ;
∘ un premier circuit amplificateur (RC1) configuré pour recopier le potentiel électrique du noeud de sortie (Vₒᵤₜ) sur le drain du premier transistor cascode de polarisation (M4) ;
∘ un second circuit amplificateur (RC2, M_{RC2}) configuré pour générer une tension (V_{casc,src}) sur la grille du premier transistor cascode de polarisation (M4) pour réguler la tension de la source dudit premier transistor cascode de polarisation (M4) à une tension de consigne prédéfinie (V_{casc}).

2. Circuit électronique (D1) selon la revendication 1 dans lequel le premier circuit amplificateur (RC1) est un amplificateur opérationnel ayant une entrée non-inverseuse connectée au noeud de sortie (11), une entrée inverseuse connectée au drain du premier transistor cascode de polarisation (M4) et une sortie connectée à la grille du transistor suiveur (M3).

3. Circuit électronique (D1) selon l'une quelconque des revendications 1 ou 2 dans lequel le deuxième circuit amplificateur (RC2) est un amplificateur opérationnel ayant une entrée non-inverseuse configurée pour recevoir une première tension de polarisation (V_{casc}), une entrée inverseuse connectée à la source du premier transistor cascode de polarisation (M4) et une sortie connectée à la grille du premier transistor cascode de polarisation (M4) et destinée à générer ladite tension régulée (V_{casc,src}).

4. Circuit électronique (D1) selon l'une quelconque des revendications 1 ou 2 dans lequel le deuxième circuit amplificateur (RC2) comprend un deuxième générateur de courant (I_{RC2}) et un premier transistor d'amplification (M_{RC2}) alimenté par ledit deuxième générateur de courant dédié (I_{RC2}) et ayant :
- une grille connectée à la source du premier transistor cascode de polarisation (M4);
- et un drain connecté à la grille du du premier transistor cascode de polarisation (M4).

5. Circuit électronique (D1) selon l'une quelconque des revendications 1 à 4 dans lequel la première branche de polarisation (BS1) comprend un second transistor cascode de polarisation (M1) monté entre le premier générateur (SC1) du courant de référence (I_{ref}) et le premier transistor de recopie de courant de polarisation (M2).

6. Circuit électronique (D1) selon la revendication 5 dans lequel le circuit de polarisation (20) comprend en outre un troisième circuit amplificateur (RC3) ayant une entrée non-inverseuse configurée pour recevoir une seconde tension de polarisation (V_{casc}), une entrée inverseuse connectée à la source du second transistor cascode de polarisation (M1) et une sortie connectée à la grille du second transistor cascode de polarisation (M1).

7. Circuit électronique (D1) selon la revendication 6 en combinaison avec la revendication 3 dans lequel la seconde tension de polarisation (V_{casc}) correspond à la première tension de polarisation (V_{casc}).

8. Circuit électronique (D1) selon la revendication 5 dans lequel le circuit de polarisation (20) comprend en outre un second transistor d'amplification (M_{RC3}) alimenté par un troisième générateur de courant dédié (I_{RC3}) et ayant une grille connectée à la source du second transistor cascode de polarisation (M1) et ayant un drain connecté à la grille du second transistor cascode de polarisation (M1).

9. Dispositif photonique à phase configurable (DP) comprenant :
- un guide d'ondes (WG) pour guider un faisceau lumineux d'entrée (REMᵢₙ) généré par une source laser (SR) ;
- une antenne (GC) d'émission ou de réception connectée au guide d'ondes (WG) ;
- un élément résistif (R1) destiné à chauffer par effet joule le guide d'ondes (WG) de manière à piloter l'indice de propagation du guide d'ondes (WG) pour configurer la phase faisceau lumineux déphasé (REM);
- un circuit électronique (D1) selon l'un quelconque des revendications 1 à 8 configuré pour injecter un courant de commande (Iₒᵤₜ) à travers l'élément résistif (R1) à partir d'un signal numérique de commande (BWC) pour piloter l'échauffement d'au moins une section du guide d'ondes (WG) ; l'élément résistif (R1) correspondant audit circuit de charge cible.

10. Réseau optique à commande de phase (OPA) configuré pour diriger un faisceau lumineux (REMₜₒₜ) selon une direction prédéterminée comprenant :
une pluralité de dispositifs photoniques à phase configurable (DP₁, DP₂, DP₃) selon la revendication 9 alimentés par une source laser (SR) commune ; chaque dispositif photonique à phase configurable (DP₀, DP₁, DP₂, DP₃) étant commandé par un signal numérique de commande (BWC₀, BWC₁, BWC₂ ,BWC₃) dédié généré par des moyens de contrôle (CONT).
